(19) Europäisches Patentamt
European Patent Office
Office européen des brevets

(11) **EP 0 589 140 B1**

(12) **EUROPEAN PATENT SPECIFICATION**

(45) Date of publication and mention
of the grant of the patent:
**04.08.1999 Bulletin 1999/31**

(51) Int Cl.⁶: **H04B 1/66**, G10L 7/04

(21) Application number: **93106842.3**

(22) Date of filing: **27.04.1993**

(54) **Bit allocation method in subband coding**

Bitzuordnungsverfahren in Teilbandkodierung

Procédé d'attribution des bits en codage par sous-bandes

(84) Designated Contracting States:
**DE FR GB**

(30) Priority: **21.09.1992 KR 1718892**

(43) Date of publication of application:
**30.03.1994 Bulletin 1994/13**

(73) Proprietor: **SAMSUNG ELECTRONICS CO., LTD.
Suwon-city, Kyungki-do 441-373 (KR)**

(72) Inventor: **Kim, Ga-yeong
Kwangmyeong-city, Kyungki-do (KR)**

(74) Representative: **Grünecker, Kinkeldey,
Stockmair & Schwanhäusser Anwaltssozietät
Maximilianstrasse 58
80538 München (DE)**

(56) References cited:
**EP-A- 0 457 390**

- **PHILIPS JOURNAL OF RESEARCH vol. 44, no.
2/3 , July 1989 , EINDHOVEN NL pages 329 - 343
VELDHUIS ET AL 'SUBBAND CODING OF
DIGITAL AUDIO SIGNALS'**

## Description

### BACKGROUND OF THE INVENTION

The present invention relates to subband coding of an audio signal, and more particularly to a bit allocation method for enhancing coding efficiency by decreasing each value of an initial bit allocation with respect to corresponding blocks of subbands.

Various audio coding methods for processing audio signals have been suggested by utilizing statistical characteristics of a temporal or frequency region and the human auditory system. The audio coding method includes a waveform coding method for coding the instantaneous amplitude of audio signals: an analysis-synthesis coding method wherein an audio generating apparatus is approximated to a model in compliance with an audio source and vocal path characteristic, and audio is displayed by a parameter of the approximation: and a high-efficiency transmission method by multiplexing wherein the existence of an audio signal on time axis is detected, and a silent section is compressed to realize the high-efficiency transmission.

Subband coding is a kind of the waveform coding method, wherein an audio signal is split into a plurality of frequency bands, the signal of each band is down-sampled at the nyquist rate to thereby be converted into a low-band signal, and then adaptive pulse code modulation is performed. In coding each band, overall audio quality can be enhanced by allocating more quantization bits to a band in which aural energy is concentrated. Also, quantization noise affects only a split band without affecting other bands. The Comité Consultatif International Télégraphique et Téléphonique (CCITT) specifies a subband coding and adaptive differential PCM (SBC-ADPCM) system which codes an audio signal of a 7KHz broad band into 64Kbits as a recommendation (see G722).

Detailed description of such subband codings of audio signals are presented in the following papers: Journal of Audio Engineering Society, Vol. 27, No. 11, pp. 855-865, November 1979; The Bell System Technical Journal, pp. 1633-1653, September 1981; IEEE Transactions on Acoustics, Speech and Signal Processing, Vol, ASSP-30, No. 5, pp. 751-765, October 1982); and Philips Journal of Research, Vol. 44, Nos. 2/3, pp. 329-343, July 1989.

In subband coding, an audio signal is split into subbands having a plurality of successive frequency bands via an analysis filter. Each subband signal $SB_m$ is quantized block-by-block via a quantizer. The quantized subband signal $QSB_m$ consists of a plurality of successive signal blocks, and each signal block has q-numbered samples. Respective samples in the signal block is quantized with an allocated number of bits $ab[m]$. Here, index m is an integer from 1 to M. The quantizer includes a bit-need determiner for determining a needed number of bits $bf[m]$ for a certain signal block in the respectively corresponding signal blocks in the subband signal $SB_m$. The needed number of bits $bf[m]$ is related to the number of bits which represents the samples of each signal block. In addition to this, the quantizer includes a bit allocator for allocating an allocable number of bits TB in order to obtain allocated number of bits $ab[m]$ in response to the needed number of bits of the corresponding signal blocks in the subband signals. The bit reallocator eliminates components which are below a threshold Wm in accordance with a noise-masking curve of the human auditory system. The quantized signal blocks are temporally divided and multiplexed, and then transmitted.

The procedure for allocating the quantization bits to each subband will be described in detail with reference to European Patent No. 457,390 A1.

First, a needed number of bits $bf[m]$ required for the quantization of each block signal is determined. At this time, needed number of bits $bf[m]$ is determined by a signal power $pwr\_m$ and a threshold Wm in each signal block of a subband signal.

Signal power $pwr\_m$ can be produced by the following equation:

$$pwr\_m = \frac{1}{q} \sum_{i=1}^{q} Si^2$$

where $S_i$ represents the amplitude of the ith signal in a block having q-sample blocks in subband signal $SB_m$. All signal powers $pwr\_m$ with respect to the corresponding blocks of subband signals from $SB_1$ to $SB_M$ are determined in accordance with the foregoing equation.

When all signal powers of the subband signals are produced, the signal powers can be given by a vector group {pwr}. By multiplying vector group {pwr} by an M × M matrix [D], and further adding a vector group {Wr}, a vector group {W} can be obtained as below:

$$\{W\} = [D]\{pwr\} + \{Wr\}$$

where [D] is a matrix of constants, whose coefficient $d_{ij}$ is multiplied by signal power $pwr\_j$ of the q-sample blocks of a subband signal SBj in order to calculate the threshold of a subband signal SBi induced by the q-sample blocks of subband signal $SB_j$, and {Wr} represents the threshold of subband signal $SB_i$.

The needed number of bits $bf[m]$ is obtained by the following equation:

$$bf[m] = K_1 \log_2 (SFm^2/3Wm)^{1/2}$$

where, $K_1$ is a constant having a value of 1, and $SF_m$ is the largest sample value among the q-sample blocks of

subband signal $SB_m$.

Thereafter, available total number of bits TB allocable to entire subbands is allocated to each subband. At this time, allocated number of bits ab[m] allocated to each subband is determined according to needed number of bits bf[m]. First, a subband jm which requires the largest number of bits among bf[m], that is bf[1], bf[2],... bf[M] is selected. Then, it is determined whether allocated number of bits ab[jm] of the selected subband is zero. If the allocated number of bits ab[jm] equals zero, the following values are assigned:

$$bf[jm]:= bf[jm] - b_1$$

$$ab[jm]:= b_1$$

$$TB:= TB - b_1$$

where TB denotes available total number of bits allocable to every subband.

If ab[jm] is not zero, the values are assigned as follows:

$$bf[jm]:= bf[jm] - b_2$$

$$ab[jm]:= ab[jm] + b_2$$

$$TB: TB - b_2$$

where $b_1$ and $b_2$ are integers and $b_1 > b_2$.

The allocation of the needed number of bits to each subband according to the above-described methods is repeated until no bit is left in available total number of bits TB, but only when the number of bits allocable to a certain subband is limited within a maximum number of bits a_max.

The sample values of the q-sample blocks in the subband signal have sign bits. Accordingly, at least two bits (the sign bit and an effective bit) are required for quantizing the sample values. Allocated number of bits ab[m] is provided to quantize the q-sample blocks of each subband in such a manner that $b_1$-bit (e.g., two bits) is allocated for a first allocation, and $b_2$-bit (e.g., one bit) is allocated for a second allocation. Here, initially allocated number of bits $b_1$ is greater than reallocated number of bits $b_2$.

In the conventional bit allocation, the initially allocated number of bits $b_1$ is different from reallocated number of bits $b_2$, which requires a separate algorithm and apparatus to thereby complicate the system.

It is the object of the invention to provide a simplified bit allocation method of subband coding.

The object is achieved by the subject matter of independent claim 1.

Preferred embodiments of the invention are defined by dependent claims.

## BRIEF DESCRIPTION OF THE DRAWINGS

The above objects and other advantages of the present invention will become more apparent by describing in detail a preferred embodiment thereof with reference to the attached drawings in which:

FIG. 1 is a flowchart showing a conventional bit allocation method;
FIG. 2 is a flowchart showing a bit allocation method according to the present invention; and
FIG. 3 is a block diagram showing an apparatus for performing the bit allocation program according to the flowchart shown in FIG. 2.

## DETAILED DESCRIPTION OF THE INVENTION

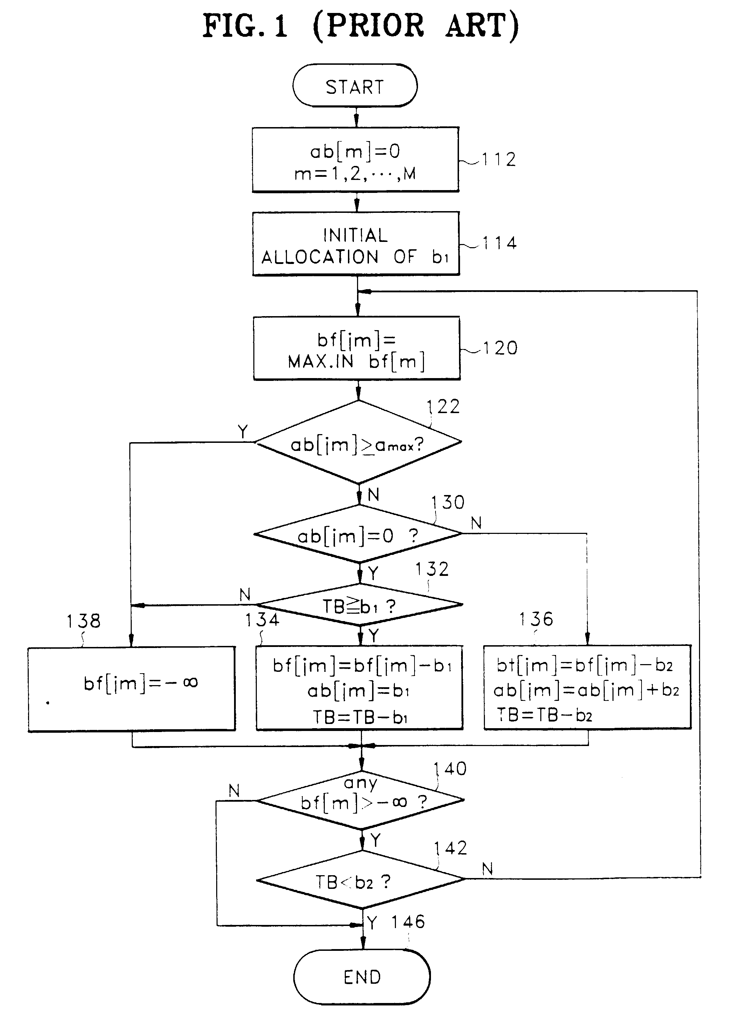

Before performing a conventional bit allocation method according to a flowchart shown in FIG. 1, a needed number of bits bf[m] required for quantizing a block having q-numbered samples in each subband signal is determined. Here, "q" is assumed as one, for convenience.

First, an allocated number of bits ab[m] which represents the number of bits allocated to the block of each subband signal is cleared (step 112).

An initially allocated number of bits $b_1$ is allocated to allocated number of bits ab[m] of a block of a subband signal $SB_m$ whose signal power pwr_m is greater than a threshold Wm among respective blocks in the subbands. Here, initially allocated number of bits $b_1$ is an integer having a value. e.g., 2 (step 114).

A needed number of bits having the largest value among the corresponding blocks of respective subbands is searched, and its index jm is obtained. Here, bf[jm] is a needed number of bits bf[m] of a subband which has the largest needed number of bits (step 120).

Then it is determined whether the allocated number of bits ab[jm] of subband jm is greater than the maximum allocated number of bits a_max. If allocated number of bits ab[jm] is greater than maximum allocated number of bits a_max, the program branches to step 138 since more bits cannot be allocated to the searched block (step 122).

If allocated number of bits ab[jm] is smaller than maximum allocated number of bits a_max, it is checked whether allocated number of bits ab[jm] equals zero. When allocated number of bits ab[jm] is not zero, the program branches to step 136 (step 130). Meanwhile, when allocated number of bits ab[jm] equals zero, it is checked whether available total number of bits TB is greater than or equal to initially allocated number of bits $b_1$. If available total number of bits TB is smaller than initially allocated number of bits $b_1$, the program branches to step 138 (step 132).

If available total number of bits TB is greater than or equal to initially allocated number of bits $b_1$, then, the following operations are executed: needed number of bits bf[jm] is replaced with a value obtained by subtracting initially allocated number of bits $b_1$ from bf[jm]; allocated number of bits ab[jm] is replaced with initially allocated number of bits $b_1$; available total number of bits TB is replaced with a value obtained by subtracting $b_1$ from TB; and the program proceeds to step 140 (step 134). Thereafter, needed number of bits bf[jm] is replaced with a value obtained by subtracting $b_2$ from bf[jm]; allocated number of bits ab[jm] is replaced with a value obtained by add $b_2$ to ab[jm]; TB is replaced with a value obtained by subtracting $b_2$ from available total number of bits TB; and the program proceeds to step 140 (step 136).

In step 138, needed number of bits bf[jm] is changed into $-\infty$, and then the program proceeds to step 140.

All needed number of bits bf[m] are checked whether they are $-\infty$ or not. When all needed number of bits bf[m] are $-\infty$, the bit reallocating program is finished (step 140).

If there is a needed number of bits bf[m] which is not $-\infty$, it is checked whether or not available total number of bits TB is larger than or equal to reallocated number of bits $b_2$. When available total number of bits TB is larger than or equal to reallocated number of bits $b_2$, the program returns to step 120. If Tb is smaller than $b_2$, the bit reallocating program is finished (step 142).

In the conventional bit allocation method shown in FIG. 1, it is checked whether allocated number of bits ab[jm] is zero, to determine the initial allocation. Then, according to the determination, when allocated number of bits ab[jm] is zero, i.e., for the initial allocation, initially allocated number of bits $b_1$ is allocated in step 134. Conversely, reallocated number of bits $b_2$ is allocated in accordance with step 136. This is because each sample of a block having q-numbered samples in a subblock has a sign bit, so that at least two bits are required for quantizing the respective samples with signs. The minimum allocated number of bits is satisfied by setting initially allocated number of bits $b_1$ to two.

However, in hardware performing the bit allocation in accordance with the flowchart shown in FIG. 1, separate blocks are required for performing the initial allocation and reallocation, which complicates the hardware.

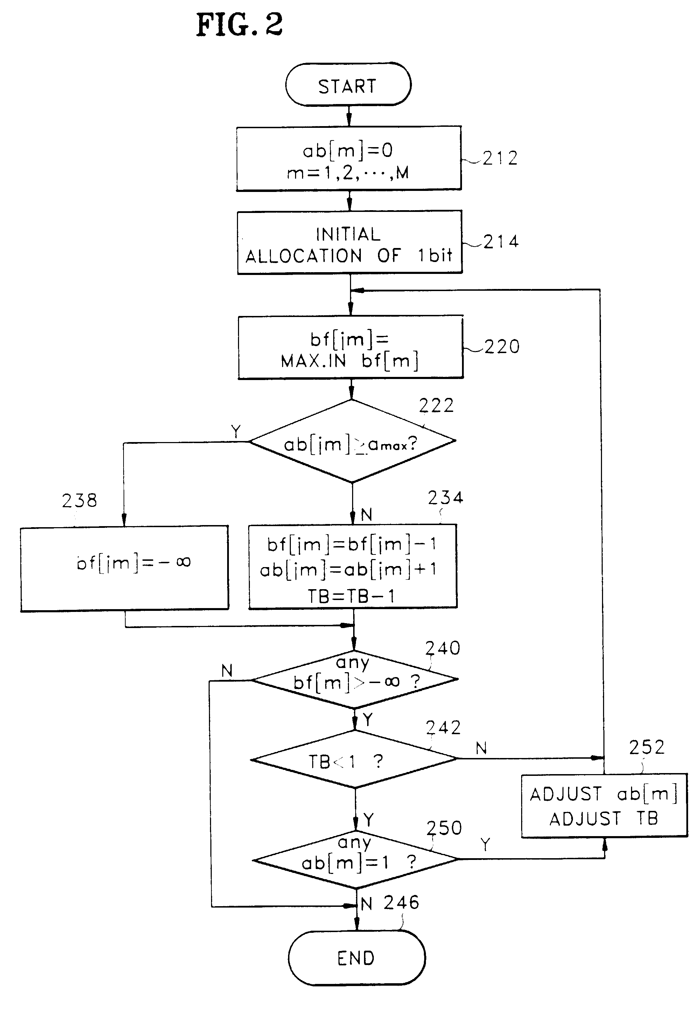

FIG. 2 is a flowchart for showing a bit allocation method according to the present invention.

First, an allocated number of bits ab[m] which represents the number of bits allocated to the block of each subband signal is cleared (step 212).

"One" is allocated to allocated number of bits ab[m] of a block of a subband whose signal power pwr_m is greater than a threshold Wm among respective blocks in the subbands (step 214).

A needed number of bits having the largest value among the blocks of respective subbands is searched, and its index jm is obtained. Here, bf[jm] is a needed number of bits bf[m] of a subband which has the largest needed number of bits (step 220).

Then, it is determined whether the allocated number of bits ab[jm] of subband jm is greater than or equal to the maximum allocated number of bits a_max. If allocated number of bits ab[jm] is greater than or equal to maximum allocated number of bits a_max, the program branches to step 238 since no more bits can be allocated to the searched block (step 222).

If allocated number of bits ab[jm] is smaller than maximum allocated number bits a_max, then, the following operations are executed: needed number of bits bf[jm] is replaced with a value obtained by subtracting "one" from bf[jm]; allocated number of bits ab[jm] is replaced with a value obtained by adding "one" to allocated number of bits ab[jm]; available total number of bits TB is replaced with a value obtained by subtracting "one" from TB; and the program proceeds to step 240 (step 234). Thereafter, in step 238, needed number of bits bf[jm] is changed into $-\infty$, and then the program proceeds to step 240.

All needed number of bits bf[m] are checked whether they are $-\infty$ or not. When all needed number of bits bf[m] are $-\infty$, the bit reallocating program is finished (step 240).

If there is a needed number of bits bf[m] which is not $-\infty$, it is checked whether or not available total number of bits TB is smaller than "one." When TB is not smaller than "one," the program returns to step 220 (step 242).

When available total number of bits TB is smaller than "one," the existence of a subband whose allocated number of bits ab[m] equals "one." If there is no subband whose allocated number of bits ab[m] equals "one," the bit reallocating program is finished (step 250).

When a subband whose allocated number of bits ab[m] equals "one" exists, available total number of bits TB is replaced with a value obtained by adding to TB the number K of the subband whose allocated number of bits ab[m] is "one," allocated number of bits ab[m] is replaced with "zero" and then the program returns to step 220 (step 252).

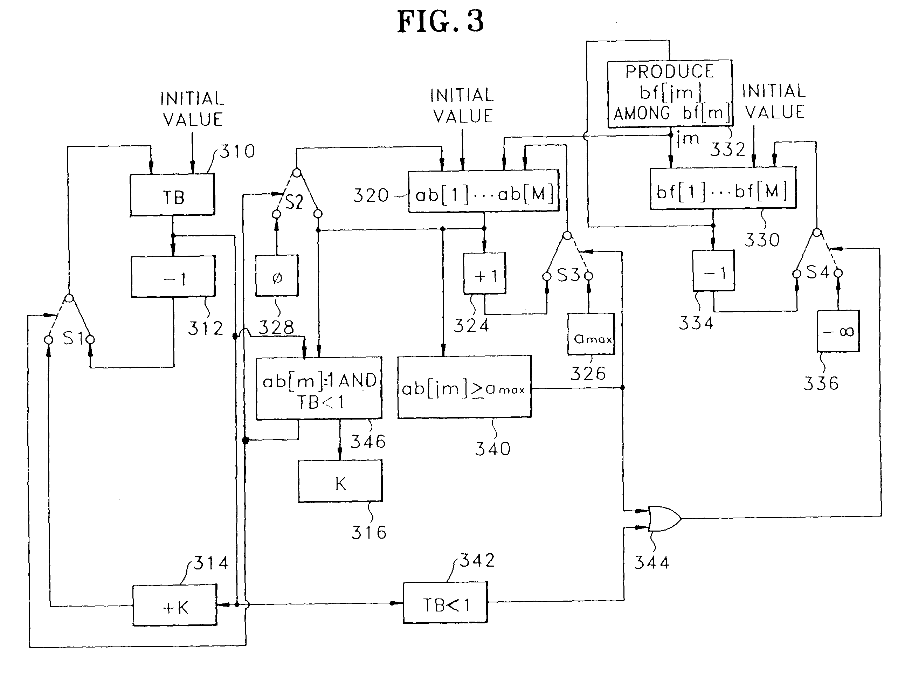

FIG. 3 is a block diagram showing an apparatus for performing the bit allocation program according to the flowchart shown in FIG. 2. The bit allocation apparatus shown in FIG. 3 has a first memory 310 which stores available total number of bits TB. Available total number of bits TB is decrement-counted one-by-one via an operation path consisting of first memory 310, first subtractor 312 and a first switch S1. Also, number K of the subband whose allocated number of bits ab[m] is "one" in step 252 is increment-counted via first memory 310, a first adder 314 and first switch S1. A first comparator 342 detects the result whether or not available total number of bits TB stored in first memory is smaller than "one," and the result is supplied to an OR operator 344.

A second memory 320 stores allocated number of bits ab[m]. Allocated number of bits ab[m] is increment-counted one-by-one via an operation path consisting of second memory 320, a second adder 324 and a third switch S3. The replacement of allocated number of bits ab[m] with "zero" in step 252 of FIG. 2, is executed via an operation path consisting of a third memory 328, a second switch S2 and second memory 320.

A second comparator 346 receives available total number of bits TB from first memory 310 and allocated number of bits ab[m] from second memory 320 to thereby detect number K of the subband which satisfies the condition (i.e., TB < 1 and ab[m]=1), so that the detected result is supplied to a fourth memory 316.

A third comparator 340 receives both allocated number of bits ab[m] of subband $SB_{jm}$ whose needed number of bits occupies the largest number among the bf[m], and stored in second memory 320, and maximum allocated number of bits a_max stored in seventh memory 326, and checks whether the condition (i.e., ab[jm] $\geq$ a_max) is satisfied. Then, the result is supplied to OR operator 344.

A fifth memory 330 stores needed number of bits bf[m] of each subband. Needed number of bits bf[m] is decrement-counted one-by-one via an operational path consisting of fifth memory 330, a second subtractor 334 and a fourth switch S4. Fourth switch S4 is driven by means of an output signal of OR operator 344, and allows - ∞ in a sixth memory 336 to be supplied to needed number of bits bf[jm] when allocated number of bits ab[jm] is more than or equal to maximum allocated number of bits a_max or available total number of bits TB is below "one."

A fourth comparator 332 detects index jm of the subband having the largest value among needed number of bits bf[m] stored in fifth memory 330, and supplies the detected value to second memory 320 and fifth memory 330.

In the bit allocation method according to the present invention, the bits allocated to the subband is consecutively increased one-by-one, so that the bit difference between subbands can be decreased.

Moreover, after finishing the bit allocation, a subband whose allocated number of bits is "one" is searched to thus collect them, which are then reallocated to other subbands, so that the bit-utilization ratio can be increased.

Furthermore, the bit allocation is incremented by one, which simplifies the hardware.

## Claims

1. A bit allocation method in a subband coding method including the steps of dividing digital data with a sampling frequency into a plurality of subband signals having successive frequency bands, dividing each subband into a plurality of blocks having q samples, and allocating ab[m] bits to block m, wherein m assumes all values from 1 to M for quantizing each sample, said bit allocation method comprising the steps of:

a first step of calculating a needed number of bits bf[m] required for quantization for each block having q samples of each subband signal;

a second step (220) of selecting a subband $SB_{jm}$ whose blocks' needed number of bits bf[jm] is the largest among the result of first step, replacing (234) said largest needed number of bits bf[jm] with a value obtained by subtracting one from it, replacing (234) a number of bits ab[jm] allocated to the blocks of subband $SB_{jm}$ with a value obtained by adding one to said allocated number of bits ab[jm], and replacing (234) the available total number of bits TB with a value obtained by subtracting one from the total number of bits TB allocable to entire blocks;

characterized by the following steps:

a third step (242) of returning to said second step (220,234) when said available total number of bits TB is more than or equal to one; and

a fourth step (252) of replacing said number of bits ab[m] allocated to block m with zero if said number of bits ab[m] allocated to block m equals one and replacing said available total number of bits TB with a value obtained by adding the number of subbands whose blocks' allocated number of bits (ab[m]) is one to said available total number of bits TB, and returning to said second step (220).

2. The bit allocation method as claimed in claim 1, wherein, after said first step, further comprises the step (214) of allocating one bit to every subband block whose power is greater than a threshold.

3. The bit allocation method as claimed in claim 1, wherein, before said step of replacing (234) said allocated number of bits (ab[jm]) with a value obtained by adding one to said allocated number of bits (ab[jm]) in said second step (220), further comprises the step (222) of ending bit allocation when said allocated number of bits (ab[jm]) is greater than or equal to a maximum allocated number of bits (a_max).

## Patentansprüche

1.  Bitzuordnungsverfahren in einem Teilbandkodierungsverfahren, das die Schritte des Einteilens digitaler Daten mit einer Abtastfrequenz in eine Vielzahl von Teilbandsignalen, die aufeinanderfolgende Frequenzbänder aufweisen, des Einteilens jedes Teilbandes in eine Vielzahl von Blöcken, die q Abtastwerte aufweisen, und des Zuordnens von ab[m] Bit zu Block m, wobei m alle Werte von 1 bis M zum Quantisieren jedes Abtastwertes annimmt, umfaßt, wobei das Bitzuordnungsverfahren die Schritte umfaßt:

    einen ersten Schritt des Berechnens einer benötigten Zahl von Bit bf[m], die zur Quantisierung jedes Blocks benötigt werden, der q Abtastwerte jedes Teilbandsignals aufweist;

    einen zweiten Schritt (220) des Auswählens eines Teilbandes $Sb_{jm}$, wobei die benötigte Zahl von Bit bf[jm] von dessen Blöcken die größte unter dem Ergebnis des ersten Schritts ist, des Ersetzens (234) der größten benötigten Zahl von Bit bf[jm] mit einem Wert, der durch Subtrahieren von 1 von ihm erhalten wird, des Ersetzens (234) einer Zahl von Bit ab[jm], die den Blöcken von Teilband $Sb_{jm}$ zugeordnet sind, durch einen Wert, der durch Addieren von 1 zu der zugeordneten Zahl von Bit ab[jm] erhalten wird, und des Ersetzens (234) der verfügbaren Gesamtzahl von Bit TB durch einen Wert, der durch Subtrahieren von 1 von der gesamten Zahl von ganzen Blöcken zuordenbaren Bit TB erhalten wird;

    **gekennzeichnet durch** die folgenden Schritte:

    einen dritten Schritt (242) des Zurückgehens zu dem zweiten Schritt (220, 234), wenn die verfügbare Gesamtzahl von Bit TB größer gleich 1 ist; und

    einem vierten Schritt (252) des Ersetzens der Zahl von Block m zugeoraneten Bit ab[m] durch 0, falls die Zahl von Block m zugeordneten Bit ab[m] gleich 1 ist und des Ersetzens der verfügbaren Gesamtzahl von Bit TB durch einen Wert, der durch Addieren der Zahl von Teilbändern, deren Blöcken zugeordnete Zahl von Bit (ab[m]) 1 ist zu der verfügbaren Gesamtzahl von Bit TB erhalten wird, und des Zurückgehens zu dem zweiten Schritt (220).

2.  Bitzuordnungsverfahren wie in Anspruch 1 beansprucht, **dadurch gekennzeichnet,** daß es nach dem ersten Schritt ferner den Schritt (214) des Zuordnens eines Bits zu jedem Teilbandblock umfaßt, dessen Potenz größer als ein Schwellenwert ist.

3.  Bitzuordnungsverfahren wie in Anspruch 1 beansprucht, **dadurch gekennzeichnet,** daß es vor den Schritt des Ersetzens (234) der zugeordneten Zahl von Bit (ab[jm]) durch einen Wert, der durch Addieren von 1 zu der zugeordneten Zahl von Bit (ab[jm]) in dem zweiten Schritt (220) erhalten wird, ferner den Schritt (222) des Beendens der Bitzuordnung umfaßt, wenn die zugeordnete Zahl von Bit (ab[jm]) größer gleich einer maximalen zugeordneten Zahl von Bit (a_max) ist.

## Revendications

1.  Procédé d'attribution des bits dans un procédé de codage par sous-bandes comprenant les étapes consistant à diviser des données numériques avec une fréquence d'échantillonnage en plusieurs signaux de sous-bandes ayant des bandes de fréquences successives, à diviser chaque sous-bande en plusieurs blocs ayant q échantillons, et à attribuer des bits ab[m] au bloc m, dans lequel m suppose toutes les valeurs de 1 à M pour quantifier chaque échantillon, ledit procédé d'attribution des bits comprenant les étapes suivantes :

    une première étape consistant à calculer un nombre de bits bf[m] nécessaire pour quantifier chaque bloc ayant q échantillons de chaque signal de sous-bande ;
    une deuxième étape (220) consistant à sélectionner une sous-bande $SB_{jm}$ dont le nombre de bits nécessaire des blocs bf[jm] est le plus grand parmi le résultat de la première étape, à remplacer (234) ledit nombre de bits nécessaire le plus grand bf[jm] par une valeur obtenue en soustrayant un de celui-ci, à remplacer (234) un nombre de bits ab[jm] attribué aux blocs de la sous-bande $SB_{jm}$ par une valeur obtenue en ajoutant un audit nombre de bits attribué ab[jm], et à remplacer (234) le nombre de bits total disponible TB par une valeur obtenue en soustrayant un du nombre de bits total TB pouvant être attribué à des blocs entiers ;

    caractérisé par les étapes suivantes :

    une troisième étape (242) consistant à retourner à ladite deuxième étape (220, 234) lorsque ledit nombre de bits total disponible TB est supérieur ou égal à un ; et
    une quatrième étape (252) consistant à remplacer ledit nombre de bits ab[m] attribué au bloc m par zéro si ledit nombre de bits ab[m] attribué au bloc m est égal à un et à remplacer ledit nombre de bits total disponible TB par une valeur obtenue en ajoutant le nombre de sous-bandes, dont le nombre de bits attribué aux blocs (ab[m]) est un, audit nombre de bits total disponible TB, et à retourner à ladite deuxième étape (220).

2.  Procédé d'attribution des bits selon la revendication 1 qui, après ladite première étape, comprend en outre l'étape (214) consistant à attribuer un bit à chaque bloc de sous-bandes dont la puissance est supérieure à un seuil.

3.  Procédé d'attribution des bits selon la revendication 1 qui, avant ladite étape consistant à remplacer (234) ledit nombre de bits attribué (ab[jm]) par une valeur obtenue en ajoutant un audit nombre de bits attribué (ab[jm]) à ladite deuxième étape (220), comprend en outre l'étape (222) consistant à terminer l'attribution des bits lorsque ledit nombre de bits attribué (ab[jm]) est supérieur ou égal à un nombre de bits attribué maximal (a_max).

# FIG. 1 (PRIOR ART)

# FIG. 2

```
        ┌──────────┐
        │  START   │
        └────┬─────┘
             │
   ┌─────────▼─────────┐
   │    ab[m]=0        │──── 212
   │  m=1,2,···,M      │
   └─────────┬─────────┘
             │
   ┌─────────▼─────────┐
   │     INITIAL       │──── 214
   │ ALLOCATION OF 1bit│
   └─────────┬─────────┘
             │
   ┌─────────▼─────────┐
   │     bf[jm]=       │──── 220
   │   MAX.IN bf[m]    │
   └─────────┬─────────┘
```

$bf[jm] = \text{MAX.IN } bf[m]$ — 220

222

$ab[jm] \geq a_{max}?$

238

$bf[jm] = -\infty$

234

$bf[jm] = bf[jm] - 1$
$ab[jm] = ab[jm] + 1$
$TB = TB - 1$

240

any $bf[m] > -\infty$ ?

242

$TB < 1$ ?

252

ADJUST ab[m]
ADJUST TB

250

any $ab[m] = 1$ ?

N 246

END

# FIG. 3